Europäisches Patentamt

European Patent Office

Office européen des brevets

(19)

(11) Numéro de publication: **0 261 013**
**A1**

(12) **DEMANDE DE BREVET EUROPEEN**

(21) Numéro de dépôt: **87401954.0**

(22) Date de dépôt: **01.09.87**

(51) Int. Cl.⁴: **H 01 L 23/48**

(30) Priorité: **05.09.86 FR 8612506**

(43) Date de publication de la demande:
**23.03.88 Bulletin 88/12**

(84) Etats contractants désignés: **DE GB IT**

(71) Demandeur: **THOMSON-CSF**
**173, Boulevard Haussmann**
**F-75379 Paris Cédex 08 (FR)**

(72) Inventeur: **Val, Christian**
**THOMSON-CSF SCPI 19, avenue de Messine**
**F-75008 Paris (FR)**

**Gagey, Bernard**
**THOMSON-CSF SCPI 19, avenue de Messine**
**F-75008 Paris (FR)**

(74) Mandataire: **Benoit, Monique et al**
**THOMSON-CSF SCPI 19, avenue de Messine**
**F-75008 Paris (FR)**

(54) **Boîtier de composant électronique muni de broches de connexion comportant un micro-boîtier amovible.**

(57) L'invention a pour objet un boîtier muni de broches de connexion et destiné à l'encapsulation d'un composant électronique, qui comporte un micro-boîtier dépourvu de broches et susceptibles d'être détaché de son boîtier support.

Il comporte :
- une partie périphérique, munie de broches (4) de connexion et permettant au boîtier (B) d'être connecté de façon standard à des équipements de test par exemple ;
- une partie centrale (MB), destinée à recevoir le composant (CI) et à former, après suppression de la partie périphérique, un micro-boîtier dépourvu de broches de connexion.

FIG_1-a

EP 0 261 013 A1

**Description**

BOITIER DE COMPOSANT ELECTRONIQUE MUNI DE BROCHES DE CONNEXION, COMPORTANT UN MICRO-BOITIER AMOVIBLE

La présente invention a pour objet un boîtier muni de broches de connexion et destiné à l'encapsulation d'un composant électronique, ce boîtier comportant un micro-boîtier dépourvu de broches et susceptible d'être détaché de son boîtier support.

Dans la description suivante, on désignera pour simplifier par "composant" tout composant électronique discret ou tout ensemble de composants formant un circuit hybride ou intégré, susceptible d'être encapsulé.

Ainsi qu'il est connu, les impératifs de miniaturisation des matériels électroniques ont conduit, notamment pour les circuits intégrés, à développer des familles de boîtiers, souvent appelés micro-boîtiers, dépourvus de broches (ou pattes) de connexion et, de ce fait, de taille très inférieure à celle des boîtiers classiques, tels que les micro-boîtiers connus sous les noms anglais de "Chip Carrier" ou "Pad Grid Array".

Toutefois, les moyens industriels actuels pour le test et le déverminage des composants ne sont souvent pas encore adaptés à ces boîtiers sans broches, ces derniers nécéssitant alors des équipements spéciaux qui en augmentent sensiblement le prix de revient.

La présente invention a pour objet un boîtier de composant électronique comportant :
- une partie périphérique, munie de broches de connexion et permettant au boîtier d'être connecté de façon standard, à des équipements de test par exemple ;
- une partie centrale, destinée à recevoir le composant et à former, après suppression de la partie périphérique, un micro-boîtier dépourvu de broches de connexion.

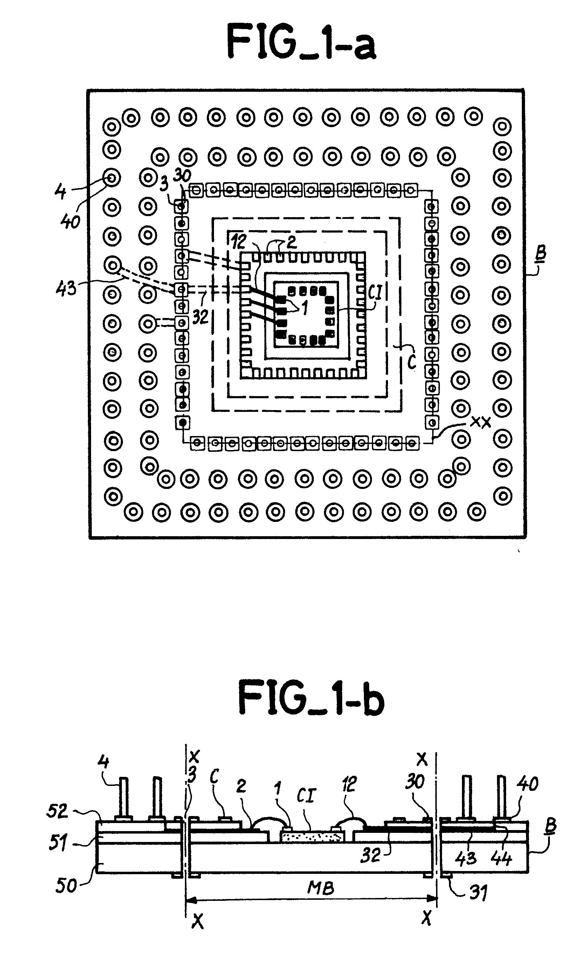

D'autres objets, particularités et résultats de l'invention ressortiront de la description suivante, donnée à titre d'exemple non limitatif et illustrée sur les dessins annexés, qui représentent :    - les figures 1, a et b, une vue de dessus et une vue en coupe d'un premier mode de réalisation du boîtier selon l'invention ;
- la figure 2, une vue de dessus du micro-boîtier dépourvu de broches de connexion, une fois détaché de son boîtier support ;
- la figure 3, un schéma explicatif ;
- la figure 4, un autre mode de réalisation du boîtier selon l'invention.

Sur ces différentes figures, les mêmes références se rapportent aux mêmes éléments. Par ailleurs, pour la lisibilité des figures, l'échelle réelle n'est pas respectée.

Les figures 1a et 1b représentent donc, vu de dessus et vu en coupe respectivement, un premier mode de réalisation du boîtier selon l'invention.

On a designé sur ces figures par B un boîtier portant un composant CI en sa partie centrale, le composant étant électriquement relié à des broches de connexion 4. Les broches 4 sont disposées à la périphérie du boîtier B, en rangées concentriques ;

le nombre de broches et leur pas font l'objet de normes et leur encombrement détermine la dimension hors tout du boitier B. Un tel boîtier est connu sous le nom anglais de "Pin Grid Array". Pour ce type de boîtier standard, il existe sur le marché des dispositifs adaptés de test et de déverminage.

Plus précisément, le boîtier B se compose d'une embase et d'un capot scellé sur cette dernière. L'embase comporte une pluralité de couches isolantes successives, repérées 50, 51 et 52, constituées par exemple par de la céramique. Le composant à encapsuler est disposé sur la couche 50. Il comporte sur sa périphérie des plots de connexion 1 qui sont reliés chacun par un fil de connexion 12 à un plot de connexion, repéré 2, disposé par exemple tout autour du composant, sur la deuxième couche (51) de l'embase. Chacun des plots 2 est relié à une pastille conductrice 40, formant la base d'une broche 4, par l'intermédiaire de pistes conductrices déposées sur l'une des couches 50-52, repérées successivement 32 et 43, puis d'un trou métallisé 44, situé par exemple au niveau de la broche 4 concernée. Lorsque ces connexions sont opérées, le composant CI est recouvert du capot dont on n'a figuré que la trace, repérée C, sur les figures 1. Le capot est disposé sur la couche supérieure 52, à l'intérieur des carrés (ou rectangles) concentriques formés par les broches 4. Le capot est par exemple métallique.

Selon l'invention, une série de trous 3 sont percés dans l'embase selon un anneau repéré XX, carré ou rectangulaire, autour du capot C. Ces trous sont métallisés et entourés de pastilles conductrices, respectivement 30 sur la face supérieure et 31 sur la face inférieure de l'embase. Les pistes conductrices rejoignant les plots 2 aux broches 4 passent chacune par un trou 3 et sont repérés 32 entre plots 2 et trous 3, puis 43 entre trous 3 et broches 4.

Après montage du composant CI dans le boîtier B, fermeture de celui-ci par le capot C, test électrique et déverminage, une découpe est effectuée alors le long de l'anneau XX, par laser par exemple, de façon à désolidariser la partie centrale, notée MN, du boitier B.

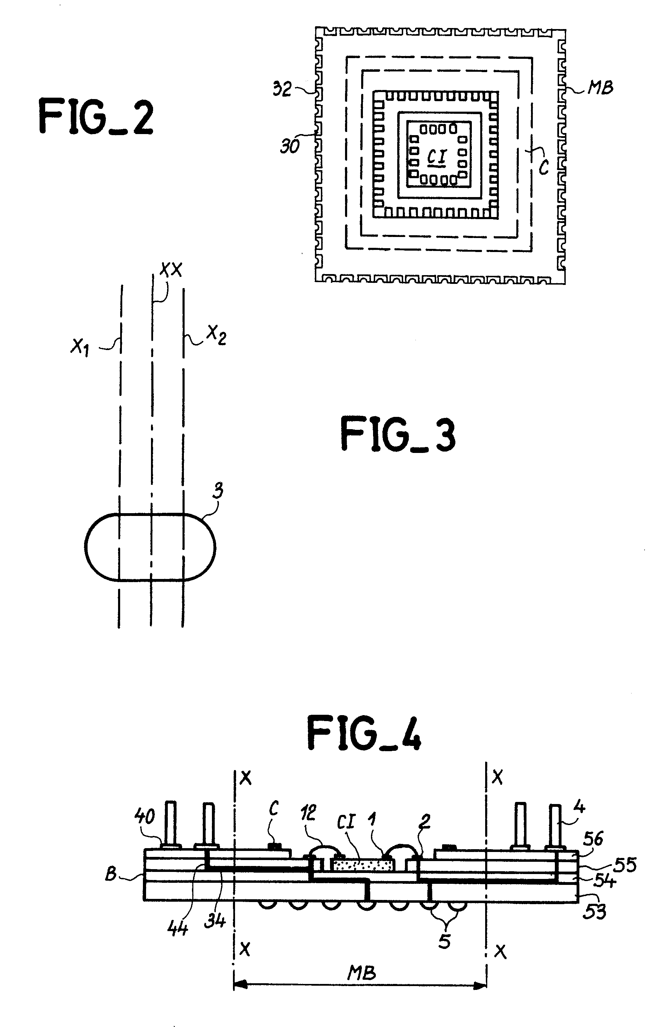

Le micro-boitier MB obtenu ainsi après découpage est illustré figure 2.

L'intérieur du micro-boîtier est identique à ce qui est représenté sur la figure 1a. La découpe selon l'anneau XX au milieu des trous métallisés 3 permet d'obtenir le mode de connexion classique des boîtiers du type "Chip Carrier", à savoir des demi-trous, maintenant repérés 32, disposés régulièrement à la périphérie du boîtier ; ils sont métallisés et se terminent sur la partie inférieure du boîtier (plots 31, figure 1b), pour constituer les connexions de ce dernier.

A titre d'exemple, il a été réalisé un boîtier du type "Pin Grid Array" à 132 broches au pas de 2,54 mm en quatre ou cinq rangées, selon les normes utilisées ; il apparaît que les trous 3 peuvent être implantés sans modification substantielle de l'implantation des pistes, la seule contrainte étant que les pistes interceptent les trous régulièrement espacés du micro-boîtier.

La figure 3 est un schéma illustrant les tolérances sur le positionnement des trous 3.

Selon l'invention, les axes des trous 3 doivent être centrés sur l'anneau XX. Toutefois, ainsi qu'il est connu, le perçage des couches par exemple de céramique (perçage effectué avant frittage) s'effectue avec une certaine tolérance qui, à l'heure actuelle, peut être de l'ordre de ± 0,8 % ce qui donne, pour des boîtiers par exemple de 20 mm de côté, une tolérance de 0,160 mm. On a illustré sur le schéma de la figure 3 la trace de l'anneau XX et deux traces qui lui sont parallèles, $X_1$ et $X_2$, de part et d'autre, représentant les limites de la tolérance.

Par ailleurs, les découpes laser se font en général avec des tolérances très inférieures à celles qui sont mentionnées ci-dessus, qui peuvent être typiquement de l'ordre de ± 0,020 mm une telle tolérance est négligeable par rapport à la précédente et on considère que la découpe laser se fait bien selon l'axe XX.

Afin de conserver de façon certaine un demi-trou 32 après découpe, on peut donner au trou 3 une forme allongée comme représenté sur la figure 3, le trou 3 s'étendant de part et d'autre des axes $X_1$ et $X_2$ de tolérance.

La figure 4 représente, vu en coupe, un autre mode de réalisation du boîtier selon l'invention, dans lequel le micro-boîtier est du type "Pad Grid Array".

Sur la figure 4, on retrouve le composant CI, placé sensiblement au milieu de l'embase du boîtier B et recouvert par un capot (traces C). L'embase du boîtier B se compose par exemple de quatre couches isolantes, repérées 53 à 56 du bas vers le haut du schéma, par exemple en céramique. Le composant CI est placé par exemple sur la couche 54 ; il est comme précédemment relié aux broches 4, disposées sur la couche supérieure (56), par l'intermédiaire des fils conducteurs 12, des plots 2 disposés sur la couche 55 et d'un jeu de pistes conductrices 34, disposées entre deux couches isolantes, et de trous métallisés 44 réalisés à travers ces mêmes couches.

Dans ce mode de réalisation, la partie inférieure du boîtier B comporte en outre des bossages 5, réalisés sur sa surface et formant les plots de connexion du micro-boîtier MB après séparation, comme précédemment, selon l'anneau XX. Chacun de ces bossages est relié à l'une des broches 4 comme le sont les trous métallisés 3 des figures précédentes. La liaison entre broches 4 et bossages 5 se fait par des trous métallisés et des pistes analogues aux trous 44 et pistes 34.

Dans une variante de réalisation non représentée, le boîtier B peut comporter des trous, analogues aux trous 3 de la figure 1, disposés régulièrement le long de l'anneau XX mais non métallisés, ayant pour seule fonction de faciliter la découpe laser ; dans ce mode de réalisation, ces trous peuvent ne pas traverser complètement l'embase du boîtier B.

La présente invention permet ainsi d'utiliser des boîtiers standards avec broches de connexion (du type Pin Grid Array), pouvant être testés et déverminés avec des moyens industriels existants, tout en permettant de disposer après le test d'un micro-boîtier sans broches, montable à plat.

## Revendications

1 Boîtier de composant électronique, caractérisé par le fait qu'il comporte :
- une partie périphérique, munie de broches (4) de connexion ;
- une partie centrale, dépourvue de broches de connexion, destinée à recevoir le composant (CI) et former un micro-boîtier (MB) détachable.

2 Boîtier selon la revendication 1, caractérisé par le fait qu'il comporte une embase et un capot et que l'embase comporte la partie périphérique et la partie centrale.

3 Boîtier selon l'une des revendications précédentes, caractérisé par le fait que le composant (CI) est électriquement connecté aux broches (4) par l'intermédiaire de pistes (32, 43, 34) et trous métallisés (44).

4 Boîtier selon la revendication 2, caractérisé par le fait que la zone de séparation (XX) entre la partie périphérique et la partie centrale comporte un ensemble de trous (3) percés dans l'embase du boîtier (B).

5 Boîtier selon les revendications 3 et 4, caractérisé par le fait que chacun des trous de l'ensemble des trous (3) traverse l'embase et est métallisé, la métallisation aboutissant à un plot (31) de connexion dont l'ensemble forme les connexions du micro-boîtier (MB), et que ces trous sont placés sur le trajet des pistes (32, 43) de sorte à être électriquement reliés aux broches (4).

6 Boîtier selon l'une des revendications 4 ou 5, caractérisé par le fait que les trous (3) de l'ensemble ont une forme oblonde couvrant les tolérences ($X_1$, $X_2$) de positionnement des trous (3).

7. Boîtier selon l'une des revendications 2 à 4, caractérisé par le fait qu'il comporte des plots de connexion en forme de bossage (45) sur la partie centrale de l'embase, électriquement reliés aux broches(4).

0261013

# FIG_1-a

# FIG_1-b

0261013

**FIG_2**

**FIG_3**

**FIG_4**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 547 795  (BOURNS) <br> * Figures 3-5, colonne 3, lignes 27-44 * <br><br> --- | 1,3,4 | H 01 L  23/48 |
| A | EP-A-0 188 838  (LABORATORIES D'ELECTRONIQUE ET DE PHYSIQUE APPLIQUEE L.E.P.) <br> * Figure 1; page 8, ligne 11 - page 10, ligne 5 * <br> --- | 1,2 | |
| A | EP-A-0 074 816  (TEXAS) <br> --- | | |
| A | DE-A-2 938 567  (SIEMENS) <br> ----- | | |

DOMAINES TECHNIQUES RECHERCHES (Int. Cl.4)

H 01 L

Le présent rapport a été établi pour toutes les revendications

| Lieu de la recherche | Date d'achèvement de la recherche | Examinateur |
|---|---|---|
| LA HAYE | 07-12-1987 | CAMPLING N.C.G. |

EPO FORM 1503 03.82 (P0402)